Europäisches Patentamt

European Patent Office

Office européen des brevets

(19)

(11) Numéro de publication: **0 351 900**
**A2**

(12) # DEMANDE DE BREVET EUROPEEN

(21) Numéro de dépôt: **89201511.6**

(51) Int. Cl.⁴: **G06F 11/22 , G01R 19/165**

(22) Date de dépôt: **12.06.89**

(30) Priorité: **17.06.88 FR 8808144**

(43) Date de publication de la demande:
**24.01.90 Bulletin 90/04**

(84) Etats contractants désignés:
**DE FR GB**

(71) Demandeur: **LABORATOIRES D'ELECTRONIQUE ET DE PHYSIQUE APPLIQUEE L.E.P.**
**3, Avenue Descartes**
**F-94450 Limeil-Brévannes(FR)**

(84) **FR**

Demandeur: **N.V. Philips' Gloeilampenfabrieken**
**Groenewoudseweg 1**
**NL-5621 BA Eindhoven(NL)**

(84) **DE GB**

(72) Inventeur: **Boutigny, Pierre-Henri**
**Société Civile S.P.I.D. 209, rue de l'Université**
**F-75007 Paris(FR)**
Inventeur: **Nguyen, Huy Anh**
**Société Civile S.P.I.D. 209, rue de l'Université**
**F-75007 Paris(FR)**
Inventeur: **Raoulx, Denis**
**Société Civile S.P.I.D. 209, rue de l'Université**
**F-75007 Paris(FR)**

(74) Mandataire: **Landousy, Christian et al**
**Société Civile S.P.I.D. 209, Rue de l'Université**
**F-75007 Paris(FR)**

(54) **Analyseur logique à multiniveaux configurable.**

(57) Analyseur logique muni de sondes (20) prélevant des signaux à tester qui sont introduits dans un numérisateur (22) muni de comparateurs qui effectuent une numérisation selon une logique à deux états. Il comprend un circuit d'aiguillage (21), disposé entre les sondes et le numérisateur qui permet d'affecter plusieurs ou tous les comparateurs à un signal à tester donné pour étendre sa numérisation à une logique à multiniveaux. Le circuit d'aiguillage (21) est constitué d'une matrice de portes de transfert MOS ou des transistors à effet de champ FET. Lorsque la logique à multiniveaux comprend au moins un état médian borné par deux références, ledit état médian est visualisé sur un dispositif de visualisation (24) selon une droite ou une courbe monotone joignant les deux références entre le début et la fin dudit état médian. Lorsque la durée dudit état médian dépasse une durée prédéterminée le dispositif de visualisation (24) est déclenché pour visualiser cet état médian.

FIG. 2

## Analyseur logique à multiniveaux configurable

L'invention concerne un analyseur logique muni de sondes prélevant des signaux à tester qui sont introduits dans un numérisateur muni de comparateurs qui effectuent une numérisation selon une logique à deux états.

Une invention de ce genre est décrite dans le document US 4 493 044 qui décrit un appareil et une méthode pour établir l'ordre selon lequel les différents signaux prélevés par des sondes doivent être visualisés dans un analyseur logique. Les différentes sondes fournissent leurs signaux à un organe de numérisation qui opère selon une logique à deux états. Les signaux numérisés sont ensuite mémorisés. Mais lorsque le dispositif sous test est complexe il peut être nécessaire d'utiliser un grand nombre de sondes et la tâche de mise en place des sondes est donc fastidieuse. Lors de la visualisation des signaux numérisés sur un écran l'ordre qui y apparaît peut nécessiter certains changements. Selon ce document, plutôt que de modifier la position des sondes sur le dispositif sous test, il est proposé d'effectuer les permutations au niveau de l'analyseur logique lui-même et donc en définitive sur l'écran. Mais les signaux numérisés mémorisés restent identiques à eux-mêmes et seule la visualisation qui en est faite s'en trouve affectée.

Or il peut être utile pour un signal à tester donné de pouvoir l'analyser avec des données plus étendues qu'une simple numérisation à deux états.

Ce problème posé doit pouvoir être résolu sans accroître outre mesure le nombre d'éléments du circuit. La solution à ce problème posé consiste en ce que l'analyseur logique comprend un circuit d'aiguillage, disposé entre les sondes et le numérisateur qui permet d'affecter plusieurs ou tous les comparateurs à un signal à tester donné pour étendre sa numérisation à une logique à multiniveaux, le circuit d'aiguillage et les références de chaque comparateur étant contrôlés par un bloc de contrôle.

Préférentiellement le circuit d'aiguillage est constitué d'une matrice de portes de transfert MOS ou des transistors à effet de champ FET. Les transistors à effet de champ peuvent être des MESFET à l'arséniure de gallium.

L'avantage de l'invention est de permettre d'observer facilement les temps de transition des signaux à tester. Les analyseurs logiques temporels sont utilisés pour l'observation des signaux numériques et sont généralement constitués de deux parties distinctes :
- une partie d'acquisition du signal qui permet de mémoriser les données numériques par l'utilisation d'une horloge d'échantillonnage et de comparateurs numérisant le signal analogique d'entrée,
- une partie de déclenchement de l'acquisition qui permet de sélectionner la partie utile du signal à enregistrer et qui s'effectue par la reconnaissance d'un évènement ou d'un groupe d'évènements prédéterminés.

Pour permettre de déterminer simplement les temps de transition la logique à multiniveaux est par exemple une logique à trois états : haut, médian, bas.

Une solution normale consisterait en l'utilisation systématique de deux comparateurs par sonde pour disposer d'une numérisation sur deux états et sur trois états, suivis d'une sélection des données numériques. Mais ceci nécessite 2N comparateurs et N multiplexeurs pour N sondes. De plus le nombre élevé de connexions véhiculant des signaux haute fréquence peut poser des problèmes de réalisation. C'est pourquoi selon l'invention le système d'aiguillage analogique des signaux est inséré entre la partie numérisation des signaux et les sondes d'entrée. Il permet d'affecter à un signal d'entrée soit un seul comparateur (numérisation à un seuil : deux états) soit deux comparateurs (numérisation à deux seuils par exemple à 20% et 80% de l'amplitude du signal), ce qui permet de distinguer trois états possibles : les états haut, bas, et l'état médian. Il est également possible d'affecter tous les comparateurs à un seul signal à tester et d'opérer selon une logique à multiniveaux. La modularité du système permet de configurer l'instrument pour l'observation en mode deux états ou multiniveaux avec un nombre déterminé et assez faible de comparateurs. Sans déplacement des sondes, on peut ainsi choisir d'examiner un signal d'entrée en mode classique (deux états) ou en mode étendu (trois états). En contrepartie, comme plusieurs comparateurs sont utilisés pour une seule voie d'entrée, le nombre de voies disponible est alors réduit.

Préférentiellement l'analyseur logique dispose d'autant de sondes que de comparateurs de sorte que chaque sonde affectée à un comparateur va permettre la numérisation d'un signal à tester sur une logique à deux états. Le passage à une numérisation à trois états nécessite d'affecter deux comparateurs à une même sonde et donc de laisser une sonde inutilisée. Le passage à une numérisation à N états nécessite d'affecter N-1 comparateurs à une même sonde et donc de laisser N-2 sondes inutilisées. Pour opérer en logique à N états il est nécessaire d'utiliser N-1 références, soit deux références pour une logique à trois états.

2

Pour présenter l'information à l'utilisateur lorsque la logique à multiniveaux comprend un état haut, un état bas et au moins un état médian borné par deux références, ledit état médian est visualisé sur un dispositif de visualisation selon une droite ou une courbe monotone joignant les deux références entre le début et la fin dudit état médian. La succession de courbes monotones peut elle-même constituer une courbe monotone.

La durée de l'état médian est caractéristique du temps de transition du signal. Lorsque cette durée dépasse une valeur prédéterminée ceci est caractéristique d'un défaut. Pour éviter que ce défaut, qui peut avoir un taux de répétition très faible, ne soit pas décelé par l'utilisateur, le bloc de contrôle détecte cet évènement et impose à l'analyseur logique d'afficher cette situation pour le signal à tester considéré. Ainsi lorsque la durée de l'état médian dépasse une durée prédéterminée le dispositif de visualisation est déclenché pour visualiser cet état médian.

L'invention sera mieux comprise à l'aide des figures suivantes données à titre d'exemples non limitatifs qui représentent :

Figures 1A à 1D : une représentation d'un signal à tester, des signaux numérisés sur deux et trois états et du signal affiché sur le dispositif de visualisation.

Figure 2 : une représentation schématique d'un analyseur logique selon l'invention.

Figure 3 : une représentation détaillée de la partie aiguillage et numérisation selon l'invention.

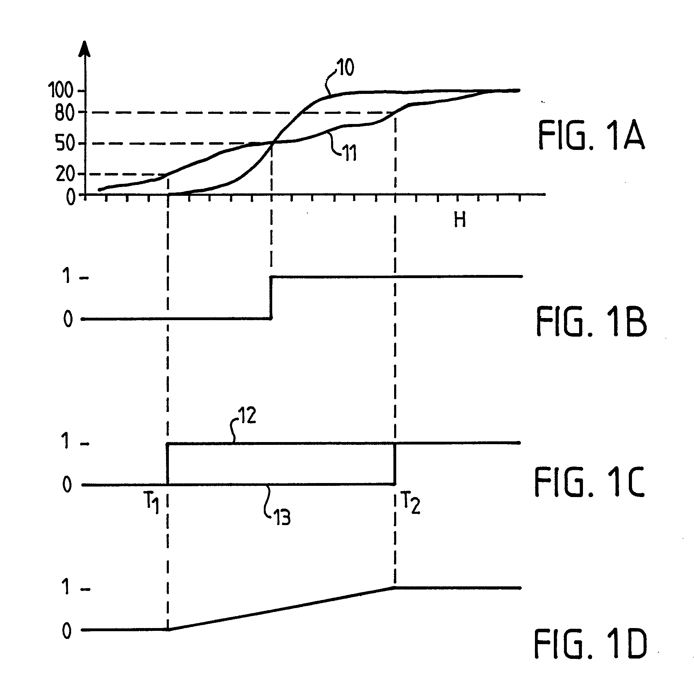

La figure 1A représente un signal analogique correct 10 et un signal défectueux 11. Si on effectue une numérisation de ces signaux sur deux états à l'aide d'un comparateur, on obtient dans les deux cas le signal numérisé de la figure 1B avec par exemple une référence placée à 50% de l'excursion maximale et en supposant ici que les deux signaux passent sensiblement par le même point milieu. Il n'est donc pas possible dans cette situation de différencier un signal correct et un signal défectueux.

La figure 1C représente par contre une numérisation sur trois états à l'aide de deux comparateurs et de deux références placées par exemple à 20% et 80% de l'excursion maximale. On obtient respectivement les signaux numérisés 12 et 13 pour les références à 20% et 80%.

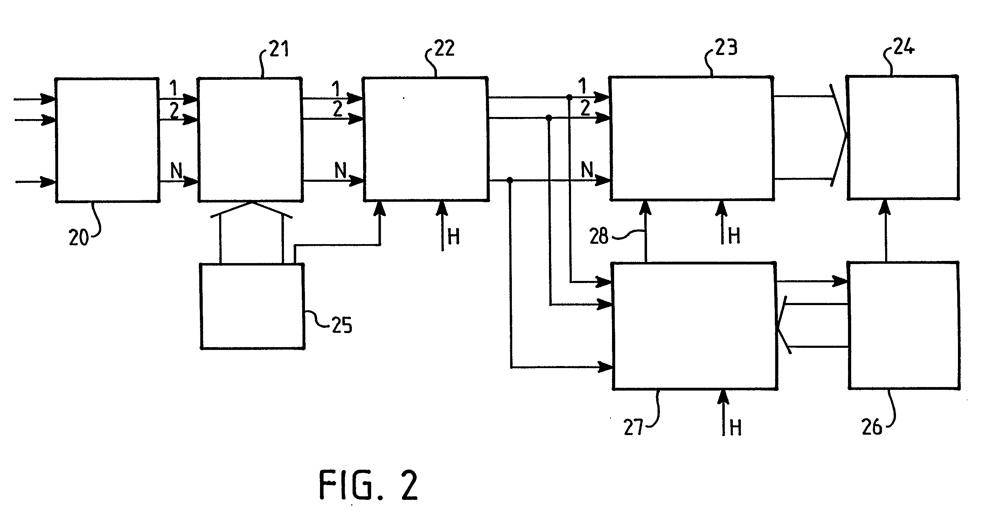

La figure 2 représente un analyseur logique comprenant des sondes 20 reliées à un circuit d'aiguillage 21 lui-même réuni à un numérisateur 22. Les signaux numérisés sont mémorisés dans une mémoire 23 et visualisés sur un dispositif de visualisation 24. Un bloc de contrôle 25 va agir simultanément sur le circuit d'aiguillage 21 et sur le numérisateur 22 pour modifier les références.

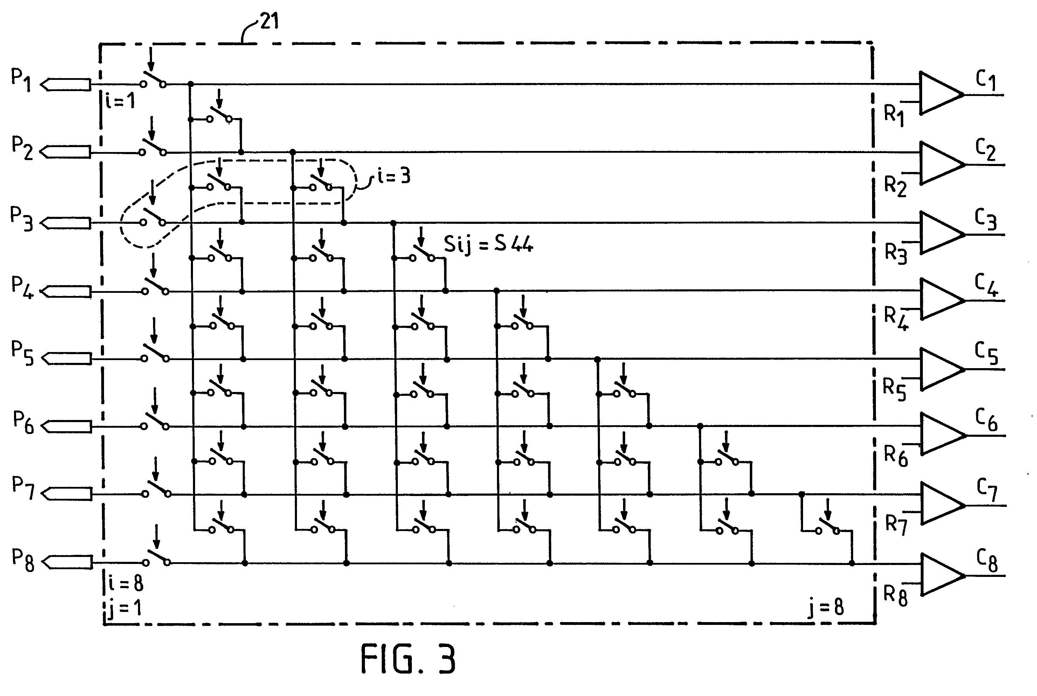

La figure 3 représente avec plus de détails le circuit d'aiguillage 21. Il est formé d'une matrice d'interrupteurs $S_{ij}$ organisés en i lignes et j colonnes avec j inférieur ou égal à i. Pour décrire plus aisément l'invention l'exemple représenté possède 8 lignes et 8 colonnes, mais n'est pas limité par le nombre de sondes à connecter. Le nombre minimum est de deux sondes qui se partagent deux comparateurs. Les sondes $P_1$ à $P_8$ forment huit voies d'entrée destinées à être reliées à des signaux à tester. Chaque sonde est reliée à un interrupteur de la première colonne. La sortie de l'interrupteur $S_{11}$ est reliée à chacun des sept interrupteurs de la deuxième colonne. Chacun de ces sept interrupteurs de la deuxième colonne est relié par l'autre borne à une des sept voies après l'interrupteur $S_{i1}$ (i = 2 à 8) placé sur cette voie. Les autres interrupteurs sont connectés de la même manière. La huitième colonne contient ainsi un seul interrupteur $S_{88}$. La sortie de chaque interrupteur $S_{11}$ à $S_{81}$ est reliée à un comparateur $C_1$ à $C_8$ qui délivre le signal numérisé selon la valeur de la référence $R_1$ à $R_8$ qui lui est connectée.

Plusieurs modes de fonctionnement sont ainsi possibles dont seulement quatre sont décrits à titre d'exemple.

Exemple 1 - Mode 8 voies à 2 états.

L'invention permet le fonctionnement habituel avec un comparateur affecté à chaque voie. Tous les interrupteurs $S_{i1}$ sont fermés et tous les autres sont ouverts. Dans ce cas généralement les références sont placées à 50%.

Exemple 2 - Mode 1 voie à 3 états et 6 voies à 2 états.

Dans ce cas le comparateur d'une voie est affecté à une autre voie et la sonde correspondante, par exemple $P_5$, se trouve inactive bien qu'elle puisse rester physiquement en contact avec son signal. Pour cela on a :

$S_{11}$ fermé et $R_1$ à 20% par exemple,

$S_{52}$ fermé et R5 à 80% par exemple.

Tous les autres interrupteurs $S_{5j}$ sont ouverts. Les autres voies opèrent comme dans l'exemple 1.

Exemple 3 - Mode 4 voies à 3 états.

Par exemple :

| - $C_1$ et $C_3$ sont affectés à la voie 1 | | | | | | | | |
|---|---|---|---|---|---|---|---|---|
| alors $S_{11}$ | : | fermé | $S_{32}$ | : | fermé | $S_{31}$ | : | ouvert |
| - $C_2$ et $C_6$ sont affectés à la voie 2 | | | | | | | | |
| alors $s_{21}$ | : | fermé | $S_{63}$ | : | fermé | $S_{61}$ | : | ouvert |
| - $C_4$ et $C_7$ sont affectés à la voie 4 | | | | | | | | |
| alors $S_{41}$ | : | fermé | $S_{75}$ | : | fermé | $S_{71}$ | : | ouvert |
| - $C_5$ et $C_8$ sont affectés à la voie 5 | | | | | | | | |
| alors $S_{51}$ | : | fermé | $S_{86}$ | : | fermé | $S_{81}$ | : | ouvert |

tous les autres interrupteurs sont ouverts.


Exemple 4 - Mode 1 voie à 9 états.

$S_{11}$ et tous les interrupteurs de la colonne 2 sont fermés et les références $R_1$ à $R_8$ sont placées à des valeurs différentes.

Si 8 comparateurs sont utilisés, on peut choisir 6 modes possibles :

8 voies 2 états
6 voies 2 états et 1 voie 3 états
4 voies 2 états et 2 voies 3 états
2 voies 2 états et 3 voies 3 états
4 voies 3 états
1 voie 9 états.

Dans tous ces exemples chaque comparateur doit avoir sa référence placée à une valeur déterminée qui dépend de la numérisation qu'il opère. Ceci est réalisé par le bloc de contrôle 25 (figure 2) qui agit également sur l'état d'ouverture ou de fermeture de chaque interrupteur.

Dans une numérisation à multiniveaux par exemple à 3 états, le signal numérisé délivré par chaque comparateur va présenter une allure représentée par la figure 1C. Avant un instant $T_1$ les deux comparateurs sont à 0 (état bas); après un instant $T_2$ les deux comparateurs sont à 1 (état haut). Entre $T_1$ et $T_2$, un des comparateurs est à 0 et l'autre à 1 (état médian).

Des moyens de contrôle 26 (figure 2) de l'analyseur logique vont permettre d'afficher sur le dispositif de visualisation 24 un segment de droite ou de courbe reliant le niveau 0 à l'instant $T_1$ au niveau 1 à l'instant $T_2$ (figure 1D), afin de présenter à l'utilisateur le résultat de la numérisation.

D'autre part le numérisateur 22 (figure 2) opérant sous le contrôle d'une horloge H, la durée entre $T_1$ et $T_2$ va pouvoir être déterminée selon un nombre de périodes de l'horloge H.

Cette durée va être comparée dans un déclencheur 27 (figure 2) qui prélève les données en sortie du numérisateur 22 et détermine si la durée $T_1$ $T_2$ est supérieure à une valeur prédéterminée. Dans l'affirmative, le temps de transition du signal à tester est donc trop grand et le déclencheur agit (connexion 28) pour que la lecture de la mémoire se fasse sur cet évènement et qu'il soit visualisé sur l'écran. Les signaux défectueux sont ainsi automatiquement visualisés, ce qui est très important lorsqu'un tel évènement a un taux de répétition faible. Le déclencheur 27 et la mémoire 23 sont également contrôlés par l'horloge H.

**Revendications**

4

1. Analyseur logique muni de sondes prélevant des signaux à tester qui sont introduits dans un numérisateur muni de comparateurs qui effectuent une numérisation selon une logique à deux états, caractérisé en ce qu'il comprend un circuit d'aiguillage, disposé entre les sondes et le numérisateur qui permet d'affecter plusieurs ou tous les comparateurs à un signal à tester donné pour étendre sa numérisation à une logique à multiniveaux, le circuit d'aiguillage et les références de chaque comparateur étant contrôlés par un bloc de contrôle.

2. Analyseur logique selon la revendication 1, caractérisé en ce que le circuit d'aiguillage est constitué d'une matrice de portes de transfert MOS ou des transistors à effet de champ FET.

3. Analyseur logique selon la revendication 2, caractérisé en ce que les transistors à effet de champ sont des MESFET à l'arséniure de gallium.

4. Analyseur logique selon une des revendications 1 à 3, caractérisé en ce que lorsque la logique à multiniveaux comprend un état haut, un état bas et au moins un état médian borné par deux références, ledit état médian est visualisé sur un dispositif de visualisation selon une droite ou une courbe monotone joignant les deux références entre le début et la fin dudit état médian.

5. Analyseur logique selon la revendication 4, caractérisé en ce que lorsque la durée dudit état médian dépasse une durée prédéterminée le dispositif de visualisation est déclenché pour visualiser cet état médian.

FIG. 1A

FIG. 1B

FIG. 1C

FIG. 1D

EP 0 351 900 A2

FIG. 2

FIG. 3

3-Ⅲ-PHF 88-550